# EUROPEAN PATENT SPECIFICATION

(11) **EP 2 515 125 B1**
(45) Date of publication and mention of the grant of the patent: **01.02.2017**
(21) Application number: 12002412.0
(22) Date of filing: 03.04.2012
(51) Int. Cl.: G01R 15/20, G01R 15/18

(54) **Current sensor with a magnetic core**
Stromsensor mit Magnetkern
Capteur de courant doté d'un noyau magnétique

(30) Priority: 21.04.2011 EP 11003399
(43) Date of publication of application: 24.10.2012
(73) Proprietor: ABB AG, 68309 Mannheim (DE)
(72) Inventor: Disselnkötter, Rolf, 69256 Mauer (DE); Hozoi, Adrian, 68219 Mannheim (DE)

(56) References cited:
- JP-A- 2003 215 169
- JP-A- 2010 223 929
- JP-A- 2010 249 789
- US-A- 4 414 543
- US-A- 5 694 103
- US-A1- 2006 290 341
- US-A1- 2008 180 096

## Description

The invention relates to a current sensor, with a ring-shaped magnetic core, said core enclosing the primary conductor with the current to be measured, said core having an air-gap, said air-gap containing a sensor element for measuring the magnetic core induction, whereby the area of the cross-section perpendicularly to the main direction of the magnetic field in the air gap is larger than the area of the cross-section of the core_perpendicularly to the circumferential direction of the ring-shaped magnetic core), according to the preamble of claim 1.

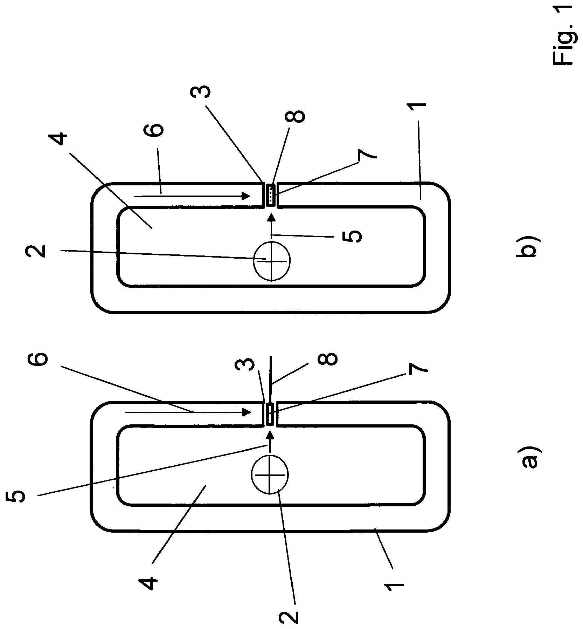

The invention particularly relates to current sensors of the two types open and closed loop, that are able to measure both AC and DC currents. These sensors feature a soft magnetic, ring-shaped, core, which encloses the primary conductor with the current that shall be measured. The core is typically composed of either a strip-wound metal tape, stacked magnetic sheet steel or bulk ferrite. The core further has an air gap, which is aligned along the circumferential direction of the core. Figure 1 shows such a configuration according to known prior art in a schematic way. Ring shaped means that the core has a contour which is nearly closed in the circumferential direction apart from the air gap, which is assumed to be small. Ring-shaped in this sense can for example be either a circular, an ovaloid or a rectangular shape.

The direction of the air-gap is here defined as the main direction of the magnetic field in the air-gap. The cross-sectional area of the air-gap is the same as the cross-sectional area of the core.

The air-gap contains a sensor element for the measurement of the magnetic core induction, which may be a Hall-sensor, an integrated circuit based Hall sensor, a magnetoresistive sensor or a fluxgate sensor.

Current sensor applications known in prior art apply a flat shaped air gap and a flat-shaped sensor element.

JP 2003215169 shows a core for forming a magnetic path of a magnetic field generating substantially no core less, in response to the voltage or current of an object to be measured. A long straight member is cut out of a base material and bently formed into a substantial square shape to form the core, sides positioned in the vicinities of both ends of the long member are bent toward an inside of the core with respect to respective sides adjacent to the sides to be positioned in parallel, and a clamping clearance for sandwiching a Hall element is formed between the sides, with an area wider than those of a surface and a reverse face of the Hall element.

JP 2010223929 shows a magnetic core for a current sensor. The magnetic core is structured such that a magnetic circuit is formed by at least one plate-like magnetic material and a gap part formed by a void provided between ends of the magnetic material by bending the magnetic material substantially circularly. The ends of the magnetic material form the gap part by facing each other at a predetermined distance from each other with predetermined areas, and at least one of the ends faces a convexly-processed surface.

US 20060290341 shows a device for measuring a current flowing in an electrical conductor having a sensor disposed in the region of the electrical conductor for measuring the magnetic field surrounding the electrical conductor. The sensor includes a magnetic circuit having a first and a second section. A magnetizing device for the saturation of the second section and an evaluation device for calculating the current flowing through the electrical conductor in dependence on measured values of the magnetic field surrounding the electrical conductor and in dependence on the applicable magnetization of the second section is also provided.

JP 2010249789 shows a magnetic compensation type current sensor. A magnetic material having a round sectional shape is molded into an approximately U-shaped form, and two cores each one end of which is processed into a flat shape are combined, and each one end not processed into the flat shape of each core is inserted respectively from both ends of a bobbin on which a secondary coil is wound, and arranged so that each one part is overlapped in contact with each other inside the bobbin, and each one end processed into the flat shape of each core is overlapped so as to form a prescribed gap in the circumferential direction, to thereby acquire a constitution so as to form an approximately circular shape as a whole.

US 20080180096 A1 shows an apparatus for measuring an electric current flowing through an electrical conductor, comprising a measuring device which detects a magnetic field formed by the electrical conductor in three orthogonal spatial directions and supplies measurement signals associated with the respective spatial directions.

US 4414543 shows a ground fault indicator for a multi-phase power distribution system includes a split-core magnetic pole assembly having a gap within which is developed a magnetic flux representative of the vector sum of the currents in the individual phase conductors of the system. A magnetic reed switch positioned within the gap responds to the summation current in the gap to trip an indicating circuit in a remotely mounted indicating module in the event of a ground fault.

US 5694103 shows an improved laminated ferromagnetic power meter core. The core is fabricated from a plurality of ferromagnetic plates. A central leg of the core has a cross-sectional area that is larger than the cross-sectional area of other parts of the core. The core gap, in which a Hall-effect sensor is located, has gap faces with chamfered or rounded over edges to reduce fringing and bypassing effects. The core is formed without discontinuous corners that can result in local saturation and, in use, accommodates electrical power conductors in an over-under looping relationship through the openings of the core to provide a more homogeneous magnetic flux within the core and thus more reliable metering.

Current sensors operating in accordance with the principle of compensation are often also called closed loop current sensors. If the current sensor is of the type closed loop, the magnetic core is provided with a secondary winding which carries a compensation current. The purpose of the compensation current is to counteract the magnetic flux densitiy generated by the primary current such that nearly zero-flux operation is ensured both at AC and DC. For this purpose a flux sensor element located in the air-gap, will detect any magnetic flux induced in this circuit and will generate a proportional signal. This signal is amplified by some electronic power stage, called booster circuit, which will generate the current through a secondary winding. The secondary current is thus opposed to the primary current, establishing a negative feedback, and will compensate its effect on the magnetic circuit.

Open and especially closed loop current sensors may be rather accurate, however, in multi-phase systems with other conductors and currents there may be an impact on the sensor accuracy from magnetic cross talk. This is mainly due to the effect of the air- gap, which causes magnetic stray fields from the core induction and at the same time a vulnerability of the current sensor to external magnetic fields.

Magnetic cross-talk sensitivity can be reduced by reducing the magnetic reluctance of the air-gap, which is proportional to the ratio between the length in the direction of the air gap and the cross-sectional area of the air-gap. With known state-of-the art current sensor designs a reduction of the magnetic reluctance is limited in cases when the core has only a small core cross section, as the length of the air-gap cannot be reduced below the minimum thickness of the flux sensor element, and the sensor requires a certain minimum lateral dimension, which means that the flux sensor element may be insufficiently shielded by the core or even protruding from the air gap and thus be exposed to the influence of external stray fields.

It is therefore the problem to be solved by the present invention to provide a current sensor with a reduction of the magnetic cross-talk sensitivity, both in an open and in a closed loop configuration, notwithstanding a potentially limited cross-sectional area of the core.

The problem is solved according to the invention by a current sensor with the features of claim 1. So according to the invention. the core is composed of a first and a second part, said first and second part, when assembled, form the ring-shaped core, and said first and second parts overlap in a first and a second overlap region with a first and a second overlap area, whereby said first overlap region forms the air-gap which is configured to contain the sensor element, and whereby said second overlap region provides direct contact between the first and the second part, and whereby the second overlap region forms a second gap filled with a soft magnetic spacer means for magnetically short-circuiting the second gap.

Cross-sectional area of the air-gap means the area of the cross-section perpendicularly to the direction of the air-gap, whereby the direction of the air-gap is defined as the main direction of the magnetic field in the air-gap. Cross-sectional area of the core means the area of the cross-section of the core perpendicularly to the circumferential direction of the core.

The advantageous effect of a current sensor design according to the invention is that the magnetic reluctance of the air-gap is reduced as far as possible, without a need to increase the cross-sectional area of the core too much. So a current sensor design according to the invention has a reduced magnetic reluctance of the air gap, whereby any limits due to the thickness of the magnetic sensor element and the size and shape of the magnetic core need not be taken into account.

According to a preferred embodiment of the invention, the direction of the air-gap is oriented in the axial direction of the ring-shaped core. The axial direction is the direction perpendicular to the plane in which the ring-shaped core lies.

According to a further preferred embodiment, the core has at least one overlap region where a first and a second end piece overlap forming an overlap area when the core is assembled in its ring-shaped form, said overlap region forming the air-gap which is configured to contain the sensor element. The cross-section of the overlap region can be made larger than the cross-section of the core, so also the cross-section of the air-gap formed in the overlap region will be larger than the cross-section of the core.

According to a further preferred embodiment, the core is composed of a first and a second part, said first and second part, when assembled, form the ring-shaped core, and said first and second parts overlap in a first and a second overlap region with a first and a second overlap area, whereby said first overlap region forms the air gap which is configured to contain the sensor element, and whereby said second overlap region provides direct contact between the first and the second part.

The core may be either of a circular, an ovaloid or a rectangular shape. In a preferred embodiment, the core is composed of at least two parts of a stacked core, made from one or several sheets of magnetic material, which form a ring that encloses the primary conductor and which overlap in two plane regions of the core.

According to a further preferred embodiment, the first and second overlap regions form first and second gaps, and the first gap is configured as air-gap to contain the sensor element, and the second gap is filled with a soft magnetic spacer means for magnetically short-circuiting the second gap. So, one of the overlaps forms a narrow gap, which contains the sensor element. The other overlap makes good magnetic contact between the two surfaces without intentional formation of an air gap.

According to a further preferred embodiment, the spacer means is made of a nonmagnetic spacer material or a second flux sensor.

According to a further preferred embodiment, the overlap area in the second overlap region is larger than the overlap area in the first overlap region. So, by using non-symmetric parts the overlap in the second overlap region can be made larger than that at the air gap in order to improve the flux transition.

Advantage of the sensor configuration according to the invention is that the cross section of the air gap is larger than the core cross section and sufficiently large to provide a good coverage and shielding of the sensor element.

In order to simultaneously form a gapped and a non-gapped plane overlap between the first and second core parts during manufacturing, at least one of the core parts may be provided with an out-of-plane bending of the metal sheets which form the stacked core. This bending can be either limited to a small zone of the core or be evenly distributed across the whole length of its circumference, e.g. in order to minimize either the area or the level of the mechanical distortion, or to keep the major part of the core in the same plane. However, any intermediate case of a bending distribution is also possible.

The metal sheets from which the stacked core is composed can be produced from large coil sheets in a single punch-bending process. Preferably they will undergo an annealing process after the mechanical processing in order to restore optimum soft magnetic properties.

The assembled core can then be fixed either by mechanical clamping, rivetting, resin impregnation, moulding, taping, or housing in a plastic case.

The sensor element can be mounted in the air-gap with its connection pins pointing either into the radial, the circumferential or into the axial direction to meet specific requirements of the application. Such specific requirements may be e.g. from the process of the formation of a secondary winding or from the mounting of the core in a case or on a printed circuit board (PCB).

In a further embodiment, two or more core parts, which can be produced from stacked, strip-wound or bulk, e.g. ferrite material, are planar, meaning unbent. They are mounted on top of each other with two overlap regions, one of which forms a gap while the other one makes a direct contact. This is achieved by tilting one core-part with respect to the other, which leads to a gap and a contact which have end faces that are not fully parallel. In order to keep the inclination small, this method is preferably used with elongated cores, where the overlap regions are on the short sides of the core.

In a further embodiment, the planar core parts are mounted on top of each other with a parallel orientation, such that equal gaps are formed in the overlap regions. The second gap can be filled either with a second sensor, a nonmagnetic spacer or with soft magnetic material, which will magnetically short-circuit the gap. In both configurations, the cross section of the overlap is larger than the core cross section.

In a further preferred embodiment, the ring-shaped core has a first, ungapped partial core and a second partial core having an air-gap which is oriented in the axial core direction, said air-gap containing a sensor element for measuring the magnetic core induction, whereby the cross-sectional area of the air-gap is larger than the cross-sectional area of the second partial core, first and second partial cores being placed on top of each other and forming a combined magnetic core that can be provided with a common secondary winding. The first partial core may in a further preferred embodiment have a larger height than the second partial core and can be made from a high saturation magnetic material.

The latter embodiment is particularly advantageous if the first partial core carrying the flux sensor has a low core height and a high quality, i.e.high µ, low Hc, core material. The aforementioned types of core designs are suited for putting them on top of a coaxial ungapped core with the same outlines, but with a larger height that is made from a high saturation magnetic material. Together, the two partial cores will then form a combined magnetic core that can be provided with a common secondary winding. By this approach it will be possible to build a closed loop current sensor, which will feature at the same time a large dynamic range, low cross-talk and low DC offset.

In a further preferred embodiment, the direction of the air-gap is oriented in the radial direction of the ring-shaped core. The radial direction is defined as being substantially perpendicular to the axial direction defined above.

In this embodiment, too, the core may have a mainly circular, ovaloid or rectangular shape, and may be made from stacked core sheets or from a few layers of thin strip-wound magnetic tape, which form a ring enclosing the primary conductor. The core may overlap in a plane region of the core, where it forms an air gap that fully encloses the flux sensor element. The core may have curved parts or local bends to generate the required overlap. It can be fixed by resin impregnation, spot welding, moulding, plastic encapsulation, etc. The cross section of the overlap is larger than the core cross section.

In a further preferred embodiment, the ring-shaped core has a first, ungapped partial core and a second partial core having an air-gap which is oriented in the radial core direction, said air-gap containing a sensor element for measuring the magnetic core induction, whereby the cross-sectional area of the air-gap is larger than the cross-sectional area of the second partial core, one of the two ring cores being located inside the other one, the first and second partial cores forming a combined magnetic core that can be provided with a common secondary winding. The first partial core may in a further preferred embodiment have a larger radial thickness than the second partial core and can be made from a high saturation magnetic material.

The latter embodiment is particularly advantageous if the first partial core carrying the flux sensor has a low radial core thickness, the same core height as the second partial core and a high quality, i.e.high µ, low Hc, core material. By this approach it will be possible to build a closed loop current sensor, which will feature at the same time a large dynamic range, low cross-talk and low DC offset.

In a further preferred embodiment, the direction of the air-gap forms an angle with the radial or the axial direction of the ring-shaped core. The angle may be around 45°, but any other angle between 10° and 80° is also preferably possible. The core may be based on strip-wound, stacked or bulk material, which can be fixed by one of the aforementioned methods.

Summarising, some of the advantages of the described solutions are:
- Large air gap cross sections can be achieved at small core cross sections.
- The sensor element is better protected from external magnetic interference.
- Full sensor coverage can be achieved also for small core cross sections.
- Space and material is saved if only small core cross sections are required.
- The air gap can be oriented along directions where interfering fields are smaller.

The present invention describes possible configurations of the core and of the air-gap aimed to reduce the cross-talk sensitivity by providing a more convenient gap orientation and reducing the magnetic reluctance of the gap beyond the typical limitation given by the cross-section of the core.

Several configurations are described below in the light of the above-mentioned description and the accompanying drawings, where:
- Figure 1: shows a core design with a sensor in the air-gap according to the prior art,
- Figure 2: shows a core design with a sensor in the air-gap according to a first embodiment of the invention ,
- Figure 3: shows a core design with a sensor in the air-gap according to a variation of the embodiment shown in fig. 2,
- Figure 4: shows a core design with a sensor in the air-gap according to a second embodiment of the invention,
- Figure 5: shows alternative core designs according to the embodiment shown in fig. 4,
- Figure 6: shows a core design with a sensor in the air-gap according to a third embodiment of the invention.

Elements with the same function and mode of operation are provided in the figures 1 to 6 with the same references.

Fig. 1 shows schematically a magnetic core design 1 known from prior art for a closed loop current sensor. The current sensor is based on a magnetic circuit comprising the magnetic core 1 of a highly permeable material. The magnetic core 1 encloses a primary conductor, here indicated by the circle with cross 2, which carries the current that is to be measured. The magnetic core has the form of substantially a rectangle with rounded corners. Apart from a small air gap 3 it has a closed circumferential contour, which is why it can well be described as a ring-shaped magnetic core 1. The ring shape of the core defines a plane 4 in which the ring-shaped core 1 lies. The cross in the circle 2 indicates the direction perpendicular to the plane 4 of the ring-shaped core 1. The direction perpendicular to the plane 4 is called the axial direction of the ring-shaped core.

In the figure the primary conductor has a direction perpendicular to the plane 4. Of course it could also have a direction with an angle different from 90° to the plane 4, in a way inclined to the plane 4.

The arrow 5 indicates a direction perpendicular to the axial direction 2 of the core 1, which is defined by the center of the core and the position of the air gap 3. This is called the radial direction 5. The arrow 6 indicates a direction which is defined by being perpendicular to both the axial and the radial direction. This is called the circumferential direction 6.

As already mentioned, the core 1 has an air-gap 3. The cross-sectional area of the air-gap is oriented perpendicularly to the circumferential direction 6 of the core 1. Thus, the cross-sectional area of the air-gap 3 is as large as the cross-sectional area of the magnetic core 1, and it cannot be made larger. Within the air-gap 3 the main direction of the magnetic field is oriented perpendicular to the cross-sectional area of the air gap 3, i.e. along the circumferential direction 6 of the core 1.

The air-gap 3 contains a sensor element 7 for the measurement of the magnetic core induction. Said sensor element may be a Hall-sensor, an integrated circuit based Hall sensor, a magnetoresistive sensor or a fluxgate sensor. It can be seen that the current sensor applies a flat shaped air gap 3 and a flat-shaped sensor element 7. In the embodiment shown in figure 1a, on the left hand side of figure 1, the connection pins 8 of the sensor element 7 are pointing into the radial direction 5. In the embodiment shown in figure 1b, on the right-hand side of figure 1, the connection pins 8 of the sensor element 7 are pointing into the axial direction 2.

When the magnetic core arrangement as shown in figure 1 is used in a closed-loop current sensor, the magnetic core 1 is provided with a secondary winding (not shown in the figures) which carries a compensation current. The purpose of the compensation current is to counteract the magnetic flux densitiy generated by the primary current such that nearly zero-flux operation is ensured both at AC and DC. For this purpose the flux sensor element 7 located in the air-gap 3, will detect any magnetic flux induced in this circuit and will generate a proportional signal. This signal is amplified by some electronic power stage (not shown in the figures), called booster circuit, which will generate the current through the secondary winding. The secondary current is thus opposed to the primary current, establishing a negative feedback, and will compensate its effect on the magnetic circuit.

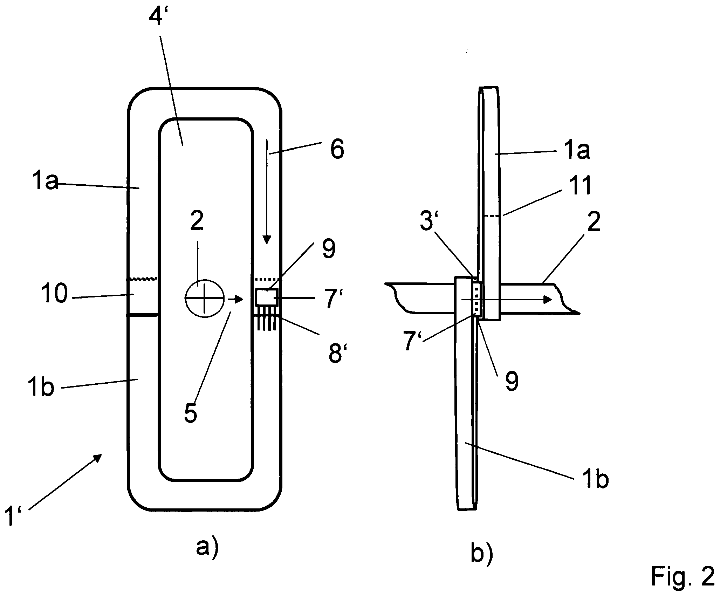

Figure 2 shows a core design with a sensor 7' in the air-gap 3' according to a first embodiment of the invention. The core 1' is composed of a first and a second part 1 a, 1 b, said first and second parts 1a, 1b, when assembled, form the ring-shaped core 1'. The first and second parts 1 a, 1 b overlap in a first and a second overlap region 9, 10 with a first and a second overlap area. The first overlap region 9 forms the air gap 3' which is configured to contain the sensor element 7'. In figure 2a on the left hand side the connection pins 8' of the sensor element 7' are directed along the circumferential direction 6 of the core 1'. Alternatively, they can be also directed along the radial direction, as in figure 1b, or in any direction in between. The second overlap region 10 provides a direct contact between the first and the second parts 1 a and 1 b.

The ring-shaped core 1' may be either of a circular, an ovaloid or a rectangular shape. In figure 2a, left hand side, the view along the axial direction of the ring-shaped core 1' is shown, where the core has a substantially rectangular shape with rounded corners. Figure 2b on the right-hand side shows a view along the radial direction of the gap, showing the assembly of the core 1' from the two overlapping parts 1 a and 1 b. In this case, the core has an oval shape and the pins of the sensor element are directed along the radial direction. It can be seen that the direction of the air-gap 3' formed in the first overlap region 9 is oriented in the axial direction 2 of the core 1'. This makes it possible that the area of the first overlap region 9 is larger than the cross-section of the core (which is indicated by the line 11 in figure 2b), and so also the cross-section of the air-gap 3' formed in the overlap region 9 is larger than the cross-section 11 of the core 1'.

Each of the first and second core parts 1 a, 1 b is a stacked core part, made from one or several sheets of magnetic material, which, when assembled to the core 1' form a ring-shaped structure that encloses the primary conductor 2 and which overlap in two plane overlap regions 9, 10 of the core.

By using non-symmetric parts the overlap area in the second overlap region 10 can be made larger than the overlap area in the first overlap region 9 which results in an improvement of the flux transition in the second overlap region 10.

An advantage of the sensor configuration according to the invention is that the cross section of the air gap is larger than the core cross section and sufficiently large to provide a good coverage and shielding of the sensor element.

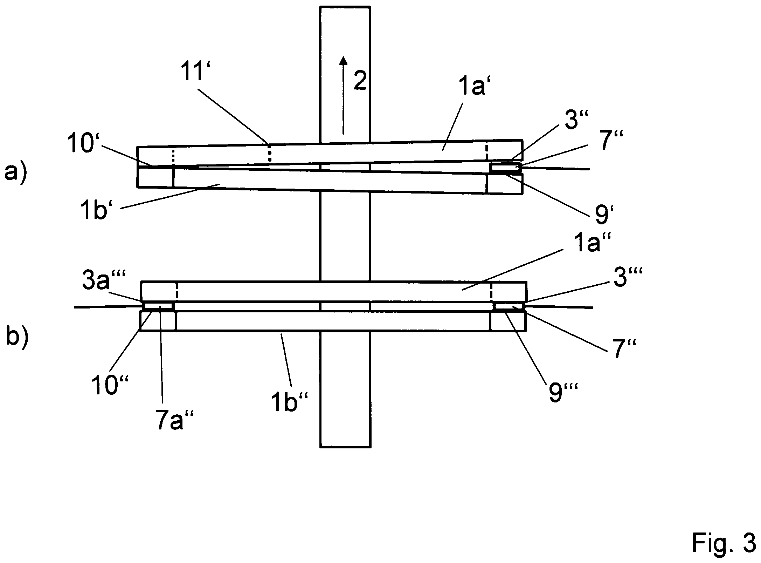

Figure 3a shows a further embodiment, where the two core parts 1a', 1b', which can be produced from stacked, strip-wound or bulk, e.g. ferrite material, are planar and unbent. They are mounted on top of each other with two overlap regions 9', 10'. The first overlap region 9' forms a gap 3", which contains the flux sensor element 7", while the second overlap region 10' makes a direct contact between the first and second part 1a', 1b'. This is achieved by tilting one of the core-parts 1 a', 1 b' with respect to the other, which leads to a gap and a contact which have end faces that are not fully parallel to each other. In order to keep the inclination small, this method is preferably used with elongated, where the overlap regions are on the short sides of the core cores.

Figure 3b shows a further embodiment where the planar core parts 1 a", 1 b"are mounted on top of each other with a parallel orientation, such that equal gaps 3"', 3a'" are formed in the overlap regions 9", 10". The gap 3a'" in the second overlap region 10" can be filled either with a second sensor 7a" (shown in figure 3b), a nonmagnetic spacer or with soft magnetic material, which will magnetically short-circuit the gap. In the two configurations, the cross section of the overlaps 9', 10', 9", 10" can be made larger than the core cross section 11'.

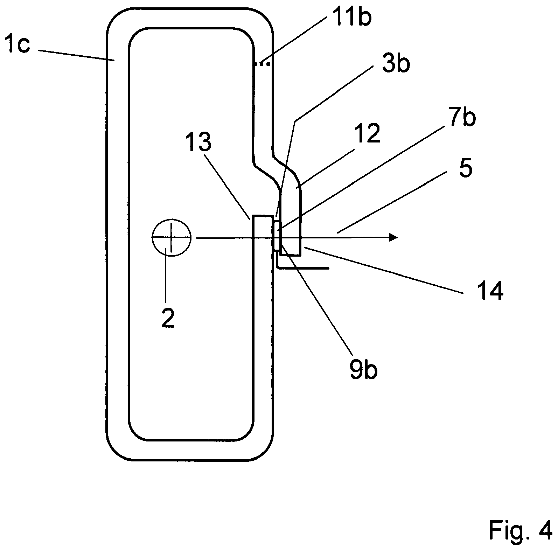

Figure 4 shows a further embodiment of the invention. It shows a core configuration, in which the air gap 3b and the sensitive axis of the sensor element 7b are oriented in the radial direction 5 of the core1c. The ring shaped core 1c, which may have a mainly circular, ovaloid or rectangular shape (in figure 4 a mainly rectangular shape is shown), is made from stacked core sheets or from a few layers of thin strip-wound magnetic tape, which form a ring-shaped structure enclosing the primary conductor 2. The two end parts 13, 14 of the core 1 c overlap in a plane region 9b, where they form an air gap 3b that fully encloses the sensor element 7b. The core 1c has a curved part 12, formed by a local bend, to generate the required overlap 9b. The two end pieces 13, 14 of the core 1c forming the overlap region 9b can be fixed by resin impregnation, spot welding, moulding, plastic encapsulation, etc. The cross section of the overlap 9b can be made larger than the core cross section 11 b.

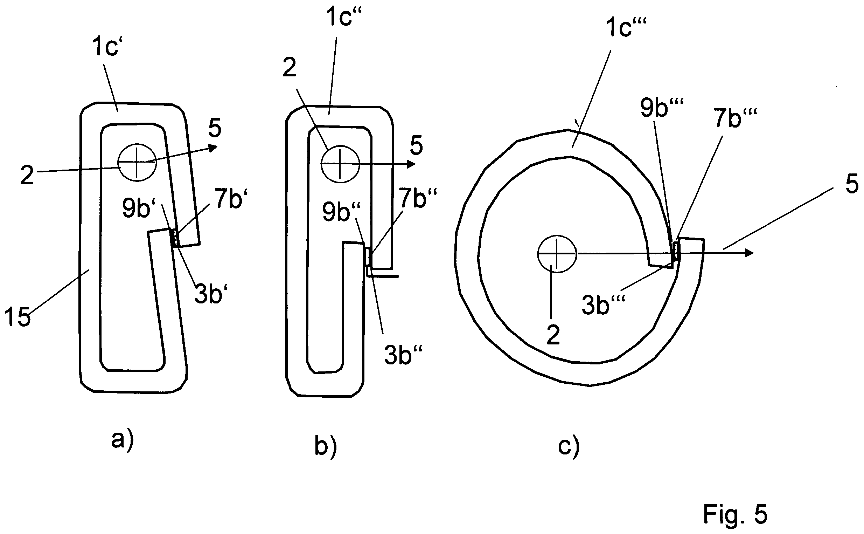

Figure 5a, b and c show alternative embodiments of the configuration, in which the air gaps 3b', 3b", 3b'" and the sensitive axis of the sensor element 7b', 7b", 7b'" are oriented in the radial direction 5 of the core 1b', 1b", 1b"'. In the configurations of figure 5 a and bthere is no curved part and no local bend close to the overlap region 9b', 9b".

Figure 5a shows an embodiment where the core has a substantially rectangular shape, the overlapping end-pieces of the core are tilted with respect to the opposite lying longitudinal branch 15. In the configuration of figure 5b the core has a substantially rectangular shape, the overlapping end-pieces of the core are in parallel to the branch 15. In the configuration of figure 5c the core has a substantially circular shape.

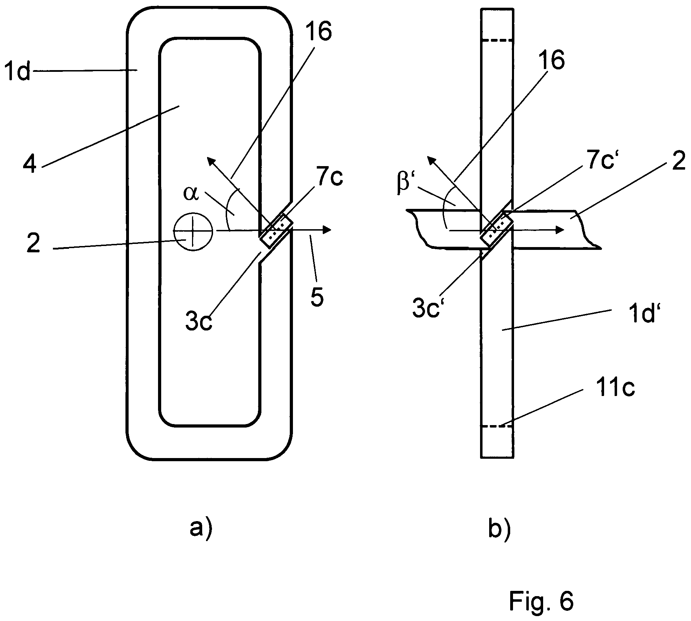

Figure 6 shows an embodiment with configurations, where the air gap is rotated by some angle around the axial or the radial axis. In figure 6a the air gap 3c and the sensitive axis 16 of the sensor element 7c are rotated by an angle α around the axial direction 5 of the core 1d. In figure 6b the gap 3c' and the sensitive axis 16' of the sensor element 7c' are rotated by an angle β around the radial direction. Any combination of such rotations is also possible. Here, the cores 1d, 1 d' have a substantially rectangular shape, other forms are also possible. Fig. 6a shows a view along the axial direction of core 1d, while figure 6b shows a view along the radial direction of the gap of core 1d'.

The angles α or β may be around 45°, but any other angle between 10° and 80° are also possible. Also, any combination of α and β from the given ranges plus 90° (the usual gap orientation) is possible. The core 1d may be based on strip-wound, stacked or bulk material, which can be fixed by one of the aforementioned methods.

The overlapping areas in the regions of the air-gaps 3c, 3c' are created by a tilted cutting of the cores 1d, 1d'. Due to the tilting of the air gaps their cross-sectional area is larger than the cross-sectional area of the core.

**Figure legend:**

| | |
|---|---|
| 1, 1' | Magnetic core |
| 1a, 1a', 1a" | First part of core 1' |
| 1b, 1b', 1b" | Second part of core 1' |
| 1c, 1c', 1c", 1c'" | Magnetic core |
| 1d, 1d' | Magnetic core |
| 2 | Primary conductor; axial direction |
| 3, 3', 3", 3"', 3a"', 3b, 3b', 3b", 3b"', 3c, 3c' | Air gap |
| 4 | Plane |
| 5 | Radial direction |
| 6 | Circumferential direction |
| 7, 7', 7", 7a", 7b, 7b', 7b", 7b"', 7c, 7c' | Sensor element |
| 8, 8' | Connection pin |
| 9, 9', 9" | First overlap region |
| 9b, 9b', 9b", 9b"' | Overlap region |
| 10, 10', 10" | Second overlap region |
| 11, 11', 11b, 11c | Cross-section of core 1' |
| 12 | Curved part |
| 13 | End piece |
| 14 | End piece |
| 15 | Longitudinal branch |
| 16, 16' | Sensitive axis of sensor element |
| | |
| | |
| | |
| | |
| | |
| | |
| | |
| | |
| | |

## Claims

1. Current sensor, with a ring-shaped magnetic core (1), said core (1) enclosing the primary conductor (2) with the current to be measured, said core (1) having an air-gap (3), said air-gap (3) containing a sensor element (7) for measuring the magnetic core (1) induction, whereby the area of the cross-section perpendicularly to the main direction of the magnetic field in the air gap (3) is larger than the area of the cross-section of the core_perpendicularly to the circumferential direction of the ring-shaped magnetic core (1), whereby the core (1) is composed of a first and a second part (1 a, 1 b), said first and second part (1a, 1b), when assembled, form the ring-shaped core (1), and said first and second parts (1 a, 1 b) overlap in a first and a second overlap region (9, 10) with a first and a second overlap area, whereby said first overlap region (9) forms the air-gap (3) which is configured to contain the sensor element (7), and whereby said second overlap region (10) provides direct contact between the first and the second part (1 a, 1 b), **characterized in that** the second overlap region forms a second gap filled with a soft magnetic spacer means for magnetically short-circuiting the second gap.

2. Current sensor (1) according to claim 1, whereby the direction of the air-gap (3) is oriented in the direction perpendicular to the plane (4) defined by the ring shape of the core (1).

3. Current sensor (1) according to claim 1, whereby the overlap area in the second overlap region (10) is larger than the overlap area in the first overlap region (9).

4. Current sensor (1) according to claim 1, whereby the direction of the air-gap (3) is oriented in a direction substantially perpendicular to the_direction perpendicular to the plane in which the ring-shaped core (1) lies.

5. Current sensor (1) according to claim 1, whereby the direction of the air-gap (3) forms an angle with the direction perpendicular to the plane in which the ring-shaped core (1) lies which is not equal to 90°.

6. Current sensor (1) according to claim 1, whereby the direction of the air-gap (3) forms an angle with the direction substantially perpendicular to the direction perpendicular to the plane in which the ring-shaped core (1) lies which is not equal to 90°.

7. Current sensor (1) according to claim 5, whereby the angle is between 10° and 80°.

8. Current sensor (1) according to claim 6, whereby the angle is between 10° and 80°.

9. Current sensor (1) according to claim 1, whereby the core (1) is formed of stacked core sheets.

## Patentansprüche

1. Stromsensor mit einem ringförmigen Magnetkern (1), wobei der Kern (1) den Primärleiter (2) mit dem zu messenden Strom umschließt und der Kern (1) einen Luftspalt (3) aufweist, wobei der Luftspalt (3) ein Sensorelement (7) zum Messen der Induktion des Magnetkerns (1) enthält, wobei die Querschnittsfläche senkrecht zur Hauptrichtung des Magnetfelds im Luftspalt (3) größer als die Querschnittsfläche des Kerns senkrecht zur Umfangsrichtung des ringförmigen Magnetkerns (1) ist, wobei der Kern (1) aus einem ersten und einem zweiten Teil (la, 1b) besteht, wobei der erste und der zweite Teil (la, 1b) den ringförmigen Kern (1) bilden, wenn sie zusammengesetzt sind, und sich der erste und der zweite Teil (la, 1b) in einem ersten und einem zweiten Überlappungsbereich (9, 10) mit einer ersten und einer zweiten Überlappungsfläche überlappen, wobei der erste Überlappungsbereich (9) den zum Enthalten des Sensorelements (7) konfigurierten Luftspalt (3) bildet, und wobei der zweite Überlappungsbereich (10) einen direkten Kontakt zwischen dem ersten und dem zweiten Teil (la, 1b) bereitstellt, **dadurch gekennzeichnet, dass** der zweite Überlappungsbereich einen zweiten Spalt bildet, der mit einem weichmagnetischen Abstandhaltemittel zum magnetischen Kurzschließen des zweiten Spalts gefüllt ist.

2. Stromsensor (1) nach Anspruch 1, wobei die Richtung des Luftspalts (3) in die Richtung senkrecht zur Ebene (4), die durch die Ringform des Kerns (1) definiert wird, ausgerichtet ist.

3. Stromsensor (1) nach Anspruch 1, wobei die Überlappungsfläche im zweiten Überlappungsbereich (10) größer als die Überlappungsfläche im ersten Überlappungsbereich (9) ist.

4. Stromsensor (1) nach Anspruch 1, wobei die Richtung des Luftspalts (3) in eine Richtung im Wesentlichen senkrecht zur Richtung senkrecht zur Ebene, in der der ringförmige Kern (1) liegt, ausgerichtet ist.

5. Stromsensor (1) nach Anspruch 1, wobei die Richtung des Luftspalts (3) einen Winkel mit der Richtung senkrecht zur Ebene, in der der ringförmige Kern (1) liegt, bildet, der nicht gleich 90° ist.

6. Stromsensor (1) nach Anspruch 1, wobei die Richtung des Luftspalts (3) einen Winkel mit der Richtung im Wesentlichen senkrecht zur Richtung senkrecht zur Ebene, in der der ringförmige Kern (1) liegt, bildet, der nicht gleich 90° ist.

7. Stromsensor (1) nach Anspruch 5, wobei der Winkel zwischen 10° und 80° liegt.

8. Stromsensor (1) nach Anspruch 6, wobei der Winkel zwischen 10° und 80° liegt.

9. Stromsensor (1) nach Anspruch 1, wobei der Kern (1) aus gestapelten Kernblechen gebildet wird.

## Revendications

1. Détecteur de courant, avec un noyau magnétique en forme d'anneau (1), ledit noyau (1) entourant le conducteur principal (2) avec le courant à mesurer, ledit noyau (1) ayant un entrefer (3), ledit entrefer (3) contenant un élément de détection (7) destiné à mesurer l'induction du noyau magnétique (1), la surface de la section transversale perpendiculairement à la direction principale du champ magnétique dans l'entrefer (3) étant supérieure à la surface de la section transversale du noyau perpendiculairement à la direction circonférentielle du noyau magnétique en forme d'anneau (1), le noyau (1) étant composé d'une première et d'une deuxième partie (1a, 1b), lesdites première et deuxième parties (1a, 1b), une fois assemblées, formant le noyau en forme d'anneau (1), et lesdites première et deuxième parties (1a, 1b) se chevauchant dans une première et une deuxième région de chevauchement (9, 10) avec une première et une deuxième surface de chevauchement, ladite première région de chevauchement (9) formant l'entrefer (3) qui est configuré pour contenir l'élément de détection (7), et ladite deuxième région de chevauchement (10) fournissant un contact direct entre la première et la deuxième partie (la, 1b), **caractérisé en ce que** la deuxième région de chevauchement forme un deuxième espace rempli avec un moyen d'entretoise magnétique douce destiné à court-circuiter magnétiquement le deuxième espace.

2. Détecteur de courant (1) selon la revendication 1, dans lequel la direction de l'entrefer (3) est orientée dans la direction perpendiculaire au plan (4) défini par la forme d'anneau du noyau (1).

3. Détecteur de courant (1) selon la revendication 1, dans lequel la surface de chevauchement dans la deuxième région de chevauchement (10) est supérieure à la surface de chevauchement dans la première région de chevauchement (9).

4. Détecteur de courant (1) selon la revendication 1, dans lequel la direction de l'entrefer (3) est orientée dans une direction sensiblement perpendiculaire à la direction perpendiculaire au plan dans lequel se trouve le noyau en forme d'anneau (1).

5. Détecteur de courant (1) selon la revendication 1, dans lequel la direction de l'entrefer (3) forme un angle avec la direction perpendiculaire au plan dans lequel se trouve le noyau en forme d'anneau (1) qui n'est pas égal à 90°.

6. Détecteur de courant (1) selon la revendication 1, dans lequel la direction de l'entrefer (3) forme un angle avec la direction sensiblement perpendiculaire à la direction perpendiculaire au plan dans lequel se trouve le noyau en forme d'anneau (1) qui n'est pas égal à 90°.

7. Détecteur de courant (1) selon la revendication 5, dans lequel l'angle fait entre 10° et 80°.

8. Détecteur de courant (1) selon la revendication 6, dans lequel l'angle fait entre 10° et 80°.

9. Détecteur de courant (1) selon la revendication 1, le noyau (1) étant constitué de feuilles de noyau empilées.
